(19) Europäisches Patentamt / European Patent Office / Office européen des brevets

(11) **EP 3 483 999 B1**

(12) **FASCICULE DE BREVET EUROPEEN**

(45) Date de publication et mention de la délivrance du brevet:
**16.06.2021 Bulletin 2021/24**

(51) Int Cl.:
**H02H 1/00** *(2006.01)* **H01B 7/32** *(2006.01)*
**H02H 5/10** *(2006.01)* **H02H 7/22** *(2006.01)*

(21) Numéro de dépôt: **18200007.5**

(22) Date de dépôt: **12.10.2018**

(54) **LIAISON ELECTRIQUE POUR LA TRANSMISSION D'UNE HAUTE TENSION A COURANT ALTERNATIF A UN EQUIPEMENT UTILISATEUR**

ELEKTRISCHE VERBINDUNG FÜR DIE ÜBERTRAGUNG EINER HOCHSPANNUNG ÜBER WECHSELSTROM AN EIN BENUTZERGERÄT

ELECTRICAL CONNECTION FOR TRANSMITTING A HIGH AC VOLTAGE TO A USER DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.11.2017 FR 1760650**

(43) Date de publication de la demande:
**15.05.2019 Bulletin 2019/20**

(73) Titulaire: **Airbus Operations S.A.S.**
**31060 Toulouse (FR)**

(72) Inventeur: **OMS, Patrick**
**31770 COLOMIERS (FR)**

(74) Mandataire: **Gicquel, Olivier Yves Gérard**
**Airbus Opérations (S.A.S)**
**XIF - M0101/1**
**316, route de Bayonne**
**31060 Toulouse Cedex (FR)**

(56) Documents cités:
EP-A2- 1 114 752 US-A1- 2006 017 445
US-A1- 2006 149 427

**EP 3 483 999 B1**

**Description**

La présente invention concerne une liaison électrique pour la transmission d'une haute tension à courant alternatif à un équipement utilisateur, ladite liaison électrique comprenant un dispositif de protection électrique pour fournir l'énergie électrique de manière sécurisée. L'invention concerne également un procédé de fourniture sécurisée d'énergie électrique à un équipement utilisateur d'un véhicule, en particulier d'un aéronef, via une liaison électrique.

Une installation électrique d'un aéronef, par exemple d'un avion de transport, comprend un générateur électrique relié à un équipement utilisateur à alimenter en énergie électrique via une liaison électrique formée d'un conducteur électrique entouré d'une enveloppe isolante. La liaison électrique comprend un dispositif de type disjoncteur pour surveiller les paramètres du signal électrique circulant à travers la liaison entre le générateur et l'équipement utilisateur afin d'interrompre un courant de surcharge ou un courant de court-circuit dans le conducteur électrique.

La puissance électrique consommée dans les aéronefs est en constante augmentation. Cette évolution conduit inévitablement à une élévation des niveaux de tension des générateurs électriques dans les aéronefs qui étaient classiquement de 115 Volts AC (AC pour « alternative current »: courant alternatif) et 28 Volts DC (DC pour « direct current »: courant continu).

On prévoit actuellement des tensions de l'ordre de +/- 270 Volts AC. Dans le futur, des tensions supérieures sont même envisagées, pouvant atteindre jusqu'à 1500 Volts AC.

De telles valeurs de tension font apparaître de nouvelles problématiques dans les aéronefs. Par exemple, des arcs électriques peuvent apparaître lors d'une fuite de courant hors de la liaison électrique. Un arc parallèle entre un conducteur électrique alimentant un équipement et la structure conductrice d'un aéronef ou entre deux conducteurs électriques adjacents pourrait endommager l'équipement utilisateur.

Les dispositifs de type disjoncteur de l'art antérieur sont efficaces à des basses tensions de l'ordre d'une trentaine de Volts, comme par exemple celui-décrit dans la demande de brevet US2006/017445, mais ne sont pas optimisés pour sécuriser la transmission d'énergie via les liaisons électriques d'installation utilisant de telles tensions, car ces derniers ne coupent la ligne de puissance qu'à des niveaux de courant importants (le courant est obligatoirement supérieur au courant consommé par les charges), et après des délais pouvant atteindre plusieurs secondes dans certains cas, entrainant donc des dommages à l'environnement du fait de la température induites par les arcs électriques et des projections de métal fondu. En effet, à de telles tensions, avec les disjoncteurs de l'art antérieur, il est obligatoire de respecter de fortes distances de sécurité entre un toron comportant des câbles d'alimentation et le châssis de l'aéronef, ou entre un toron comportant des câbles d'alimentation et un autre toron comportant des câbles de transmission de données, pour éviter qu'un éventuel arc électrique dans le toron comportant des câbles d'alimentation n'endommage par effet thermique la structure conductrice de l'aéronef ou le toron comportant des câbles de transmission de données. Ces obligations de sécurité génèrent de fortes contraintes d'espace dans un aéronef.

Il existe un besoin de trouver un dispositif de protection électrique d'une liaison électrique permettant de sécuriser la fourniture en énergie électrique à haute tension alternative à un équipement utilisateur d'un véhicule, surmontant tout ou en partie l'inconvénient de l'art antérieur susmentionné.

À cet effet, l'invention concerne une liaison électrique destinée à relier un générateur de haute tension à courant alternatif à un équipement utilisateur, telle que revendiquée à la revendication 1.

La liaison électrique selon l'invention permet, grâce au dispositif de protection électrique, de vérifier l'intégrité du conducteur électrique transportant la haute tension alternative jusqu'à l'équipement utilisateur ainsi que l'intégrité de la gaine conductrice qui compose une partie du dispositif de protection électrique et d'activer le coupe-circuit si une fuite de courant est détectée.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :

- la figure 1 représente un aéronef comportant une installation électrique ayant une source d'alimentation connectée à un équipement utilisateur via une liaison électrique et une ligne de retour de courant, et un dispositif de protection électrique de liaison électrique selon un mode de réalisation de l'invention ;
- la figure 2 représente un schéma bloc de l'installation électrique représentée à la figure 1, et une représentation du dispositif de protection électrique de la liaison électrique selon un mode de réalisation de l'invention ;
- la figure 3 représente une vue schématique d'une gaine conductrice entourant la liaison électrique et formant une partie du dispositif de protection électrique selon l'invention ;
- la figure 4 représente un schéma électrique de l'installation électrique représentée à la figure 2 ;
- la figure 5 illustre la variation au cours du temps des tensions aux bornes du module de détection, à savoir la haute tension alternative principale, la tension test et les composantes continue et alternative de la tension test ;
- la figure 6 représente la variation au cours du temps des différentes tensions et de la valeur de puissance instantanée dans le module de détection en l'absence de fuite de courant ;

- la figure 7 illustre la variation au cours du temps de la composante alternative de la tension test en présence d'une fuite de courant et du second signal de sortie du premier comparateur ;
- la figure 8 représente la variation au cours du temps des différentes tensions et puissances dans le module de détection en présence de fuite de courant ;
- la figure 9 illustre la variation au cours du temps de la composante continue de la tension de test en présence d'une fuite de courant et du premier signal de sortie du second comparateur.

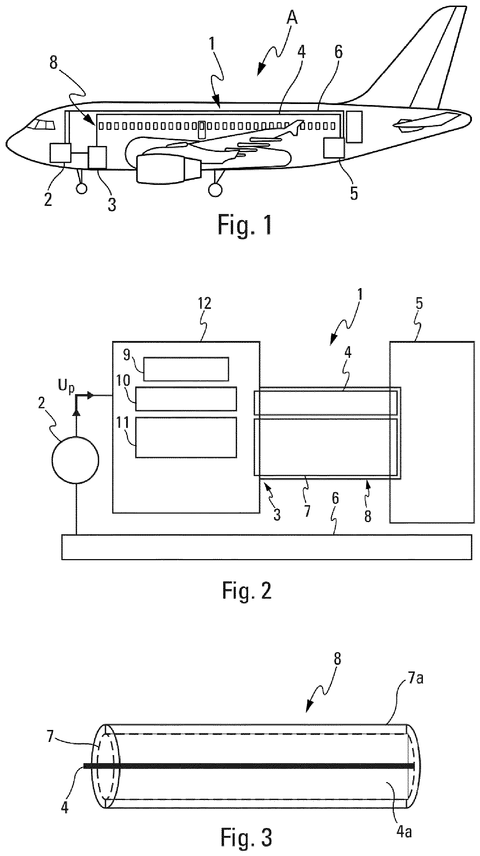

En relation avec la figure 1, un aéronef A comporte une installation électrique possédant un générateur de haute tension alternative 2 connecté à un équipement utilisateur 5 via une liaison électrique 8 et comprenant un dispositif de protection électrique 3 associé à la liaison électrique 8. Le générateur de haute tension alternative 2 est en outre relié à l'équipement utilisateur 5 par une ligne de retour de courant 6.

Le générateur de haute tension est, par exemple, susceptible de fournir une tension alternative principale Up de l'ordre de plus ou moins 270 Volts AC, ou de plus ou de plus ou moins 540 Volts AC.

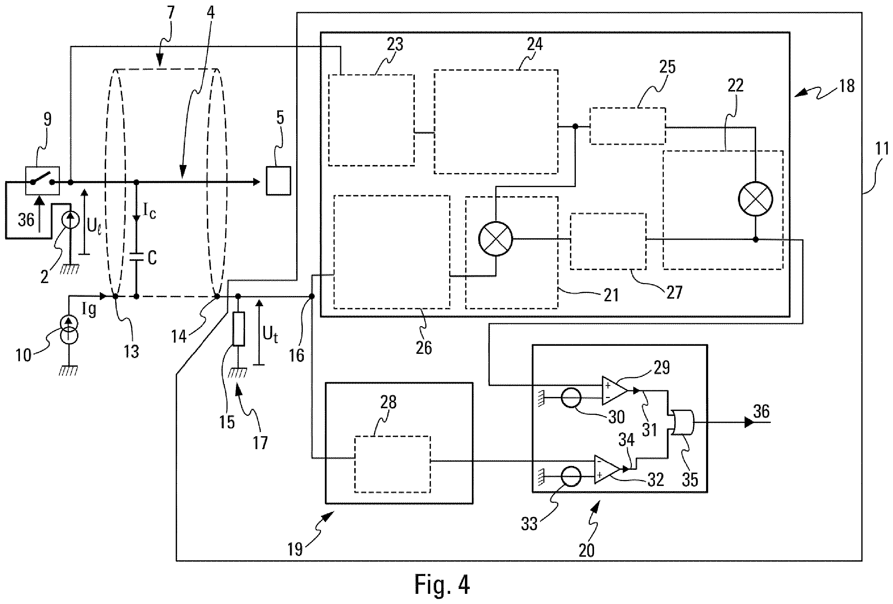

L'aéronef A comprend en outre une structure conductrice (non représentée) qui est formée par tout élément métallique/conducteur de l'aéronef qui est au potentiel de référence et forme la masse 17 (visible sur la figure 4).

En référence avec les figures 2 à 3 et selon l'invention, la liaison électrique 8 comprend un conducteur 4 entouré d'une enveloppe isolante 4a électriquement (ci-après enveloppe isolante interne 4a), par exemple une gaine plastique, et un dispositif de protection électrique 3 qui comprend une partie agencée sur l'enveloppe isolante interne 4a du conducteur électrique 4 et une partie comprenant des dispositifs électroniques, par exemple agencés dans un boîtier sécurisé 12.

La partie agencée sur l'enveloppe isolante interne 4a comprend une gaine conductrice entourée d'une enveloppe électriquement isolante 7a (ci-après enveloppe isolante externe 7a), la gaine conductrice 7 entourant l'enveloppe isolante interne 4a du conducteur électrique 4.

Comme représenté sur la figure 2, la partie située dans le boîtier 12 comprend ;

- un coupe-circuit 9 activable, qui est relié au générateur de haute tension alternative 2 et qui, lorsqu'il est activé en ce sens, permet d'interrompre la fourniture de la tension alternative principale Up à l'équipement utilisateur 5. De manière connue, le coupe-circuit 9 fonctionne comme un interrupteur qui, lorsqu'il est activé, s'ouvre, ce qui coupe la liaison électrique 8 et produit la mise hors tension du conducteur électrique 4 ;
- un générateur de courant continue fixe 10 ; et
- un module de détection 11 pour détecter une fuite de courant hors du conducteur électrique 4 ou entre la gaine conductrice 7 et l'extérieur de la liaison électrique 8.

Une fuite de courant se produit lorsque la liaison électrique 8 est endommagée. Par exemple, lorsque l'enveloppe isolante interne 4a est endommagée, un contact se produit entre le conducteur électrique 4 et la gaine conductrice 7. De même, lorsque l'enveloppe isolante externe 7a est défaillante, la gaine conductrice se trouve en contact avec un élément extérieur à la liaison électrique 8.

Un endommagement du conducteur 8 peut entraîner la création d'un arc électrique hautement énergétique entre le conducteur 4 et la structure conductrice de l'aéronef, ou la ligne de retour de courant 6, ou un autre conducteur mis à un potentiel différent de celui du conducteur électrique 4.

La liaison électrique 8 s'étend avantageusement du boîtier 12 jusqu'à l'équipement utilisateur 5 (seule une portion de la liaison électrique a été représentée sur la figure 4).

Le générateur de courant continu fixe 10 assure la fonction de polarisation en courant de la gaine conductrice 7 en injectant un courant de polarisation Ig continu sur la gaine conductrice 7 à un point d'injection du courant 13 qui est, par exemple, situé au niveau de l'extrémité amont (côté boîtier 12) de la liaison électrique 8.

Le générateur de courant continu fixe 10 est de préférence limité en tension avec une limitation en tension choisie pour être non dangereuse pour les personnes physiques, typiquement une tension Ug inférieure à 50 Volts. Cette option préférentielle permet d'ajouter un degré de protection supplémentaire pour les personnes physiques.

Par exemple, le courant continu de polarisation Ig, délivré par le générateur 10 est de 0,5A pour une tension alternative principale Up de 540 Volts AC délivrée par le générateur de haute tension alternative 2.

Dans un mode de réalisation préféré, représenté sur la figure 4, le module de détection 11 est agencé en aval de la gaine conductrice 7 et comprend une résistance shunt 15, un module de mesure du courant actif 18, un module de mesure du courant continu 19 et un module de détection de déviation des courants actif et continu 20.

L'agencement et le fonctionnement de ces divers éléments sont explicités ci-après.

La résistance shunt 15, dont la valeur Rs est connue, est agencée en aval d'un point de prélèvement 14 et en amont d'un point de mesure de courant 16. La tension test Ut mesurable aux bornes de la résistance shunt 15 est proportionnelle à la valeur Rs et à un courant test It (Ut=Rs.It). Le courant test It correspond à la somme de deux courants, à savoir, d'une part, le courant de polarisation Ig produit par le générateur de courant continue fixe 10 au point d'injection de courant 16, d'autre part un courant alternatif Ic proportionnel à une tension alternative Uc. La tension alternative Uc est créée par diaphonie capacitive entre le conducteur électrique 4 et la gaine conductrice 7. Cette diaphonie capacitive se manifeste de manière similaire à la présence d'un condensateur de valeur capacitive C entre le conducteur électrique 4 et la gaine conductrice 7 dont la valeur dépend de plusieurs paramètres (longueurs et rayons internes du conducteur électrique 4 et de la gaine conductrice 7, permitivité relative de l'enveloppe isolante interne 4a). La tension Uc s'écrit :

$$Uc=Up.Rs/(Rs+1/(2.\pi.F.C)),$$

où F représente la fréquence du générateur de haute tension alternative 2.

En l'absence de courant de fuite, c'est-à-dire dans un mode nominal, la tension Ut comprend une composante continue correspondant à une tension Ug, proportionnelle au courant de polarisation Ig, et une composante alternative Uc. En outre, le couplage entre le conducteur électrique 4 et la gaine conductrice 7 étant purement capacitif, la tension alternative Uc présente un déphasage $\varphi=-\pi/2$ par rapport à la tension alternative principale Up.

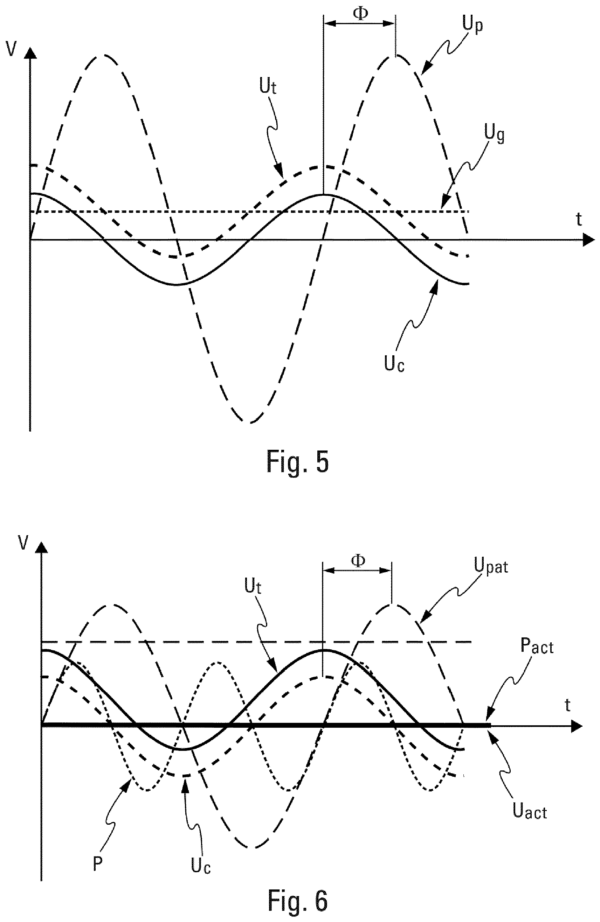

La figure 5 représente le comportement des variations, en volts V, en fonction du temps t de la tensions test Ut, de la tension alternative Uc, d'une tension Ug proportionnelle au courant de polarisation Ig, et de la tension alternative principale Up.

Comme représenté sur la figure 4, le module de mesure du courant actif 18 comprend deux bornes d'entrée connectées respectivement au générateur de haute tension alternative 2 et au point de mesure de courant 16. Ces bornes d'entrée fournissent respectivement la tension alternative principale Up et la tension test Ut. Le module de mesure du courant actif 18 comprend un élément multiplicateur 21 qui est configuré pour multiplier la tension alternative principale Up par la tension test Ut et déterminer une valeur de puissance instantanée P. Une fois la valeur de puissance instantanée P obtenue, l'élément multiplicateur 21 transmet la valeur de puissance instantanée P à un élément diviseur 22 via un filtre 27 permettant de transformer cette puissance instantanée en puissance active moyenne. L'élément diviseur 22 est configuré pour diviser cette valeur de puissance active moyenne par la valeur efficace de la tension alternative principale Up afin de déterminer puis de transmettre une première tension Uact, cette première tension Uact étant la tension image du courant actif traversant la résistance shunt 15, dite tension image Uact dans la suite de la description.

À titre d'exemple, les éléments multiplicateur 21 et diviseur 22 peuvent comprendre des composants de type Analog Device AD633.

Le module de mesure du courant continu 19 est connecté en aval de la résistance shunt 15 et en amont du module de détection de déviation des courants actif et continu 20. Il est destiné à fournir une seconde tension Utdc et comprend un filtre passe-bas 28. Ce filtre passe-bas 28 est configuré pour ne laisser passer que la composante continue Utdc de la tension test, qui correspond, dans la suite de la description, à la seconde tension. À titre d'exemple, le filtre passe-bas 28 est un filtre du 3$^e$ ordre.

Le module de détection de déviation des courants actif et continu 20 est agencé en aval des modules de mesure des courants actif et continu 18 et 19 et comprend un premier et un second comparateur 29 et 32 ainsi qu'un microcontrôleur 35.

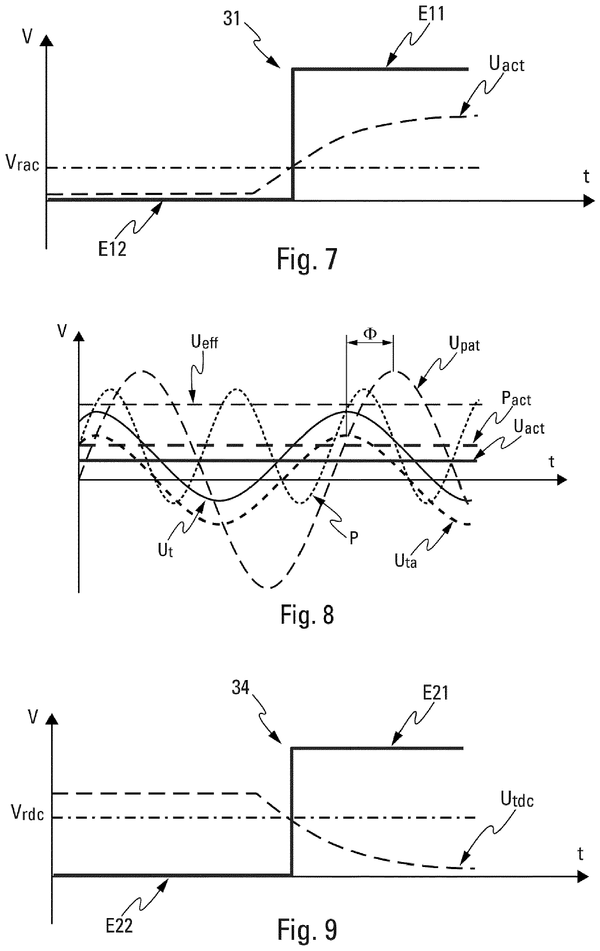

Le premier comparateur 29 est configuré pour comparer la tension image Uact à une tension de référence Vrac. La valeur de la tension image Uact est fournie par le module de mesure de courant actif 18 à une première borne d'entrée et la tension de référence Vrac est fournie à une seconde borne d'entrée par un générateur de tension continue de référence 30. Cette tension continue de référence Vrac est définie afin de tenir compte des courants de fuite non dommageables et normaux qui peuvent apparaître dans l'installation électrique. Le premier comparateur 29 émet une information sur le résultat de la comparaison sous la forme d'un signal de sortie 31 dont l'état est représentatif du résultat. Dans l'exemple représenté sur la figure 7, la valeur de la tension image Uact devient supérieure à la tension continue de référence Vrac au cours du temps, le signal de sortie 31 du premier comparateur 29 passe d'un second état E12 à un premier état E11.

Le second comparateur 32 est configuré pour comparer la composante continue Utdc de la tension test Ut à une tension de référence Vrdc. La composante continue Utdc de la tension test Ut est fournie par le module de mesure du courant continu 19 à une première borne d'entrée et la tension de référence Vrdc est fournie à une seconde borne d'entrée par un générateur de tension continue de référence 33. Cette tension continue de référence Vrdc est définie afin de tenir compte des courants de fuite non dommageables et normaux qui peuvent apparaître dans l'installation électrique. De manière analogue au premier comparateur 29, le second comparateur 32 émet une information sur le résultat de la comparaison sous la forme d'un signal de sortie 34 dont l'état est représentatif du résultat. Comme le montre la figure 9, la composante continue de la tension test Utdc devient inférieure à la tension continue de référence Vrdc au cours du temps, le signal de sortie 34 du second comparateur 32 passe d'un second état E22 à un premier état E21.

Le microcontrôleur 35 est connecté entre les premier et second comparateurs 29 et 32 et le coupe-circuit 9. Le microcontrôleur 35 est configuré pour surveiller un changement d'état des signaux de sortie 31 et 34 des premier et second comparateurs 29 et 32, afin de détecter une fuite de courant entre le conducteur électrique 4 et la gaine conductrice 7, ou la présence d'une fuite de courant hors de de la gaine conductrice 7 vers la structure de l'aéronef ou un autre conducteur. Cela signifie qu'un changement d'un second état E12 à un premier état E11 du signal de sortie 31 du premier comparateur 29 et/ou un changement d'un second état E22 à un premier état E21 du signal de sortie 34 du second comparateur 32 suffit au microcontrôleur 35 pour qu'il envoie un signal d'activation au coupe-circuit 9.

Dans un mode de réalisation particulier, le module de mesure de courant actif 18 comprend un élément atténuateur 23 et un filtre passe-bande 24 connectés ensemble successivement. Ces deux éléments sont également connectés en amont des éléments multiplicateur 21 et diviseur 22 et en aval du générateur de haute tension alternative 2. L'élément atténuateur 23 peut comprendre un amplificateur opérationnel en montage non inverseur, configuré pour atténuer la valeur de la tension alternative principale Up. Le facteur d'atténuation est défini afin de rendre compatible la tension alternative principale Up avec des éléments électriques supportant des basses tensions (tension alternative inférieure à 15 Volts AC). Par exemple, le facteur d'atténuation peut être de 1500. L'élément atténuateur 23 fournit une tension alternative principale atténuée Upat.

Le filtre passe-bande 24 est configuré pour filtrer la tension alternative principale atténuée Upat afin d'éliminer toutes les perturbations potentielles qui pourrait gêner la détection d'une fuite de courant, par exemple, la présence de décharges partielles, des impulsions électromagnétiques, ... À titre d'exemple, le filtre passe-bande 24 est un filtre du 3e ordre.

Selon une configuration, un élément convertisseur 25 est connecté entre le filtre passe-bande 24 et l'élément diviseur 22. L'élément convertisseur 25 est configuré pour convertir la tension alternative principale atténuée Upat en une valeur moyenne continue de la tension efficace Ueff. À titre d'exemple, l'élément convertisseur 25 peut comporter un composant de type Analog Device AD636.

En outre, un autre filtre passe-bande 26 est agencé entre le point de mesure de courant 16 et l'élément multiplicateur 21. Le filtre passe-bande 26 est configuré pour d'une part, filtrer la tension test Ut afin d'éliminer toute les perturbations potentielles telles que des décharges partielles ou des impulsions électromagnétique et d'autre part, éliminer la composante continue de la tension test Ut. Le filtre passe-bande 26 transmet alors seulement une composante alternative filtrée de la tension test Ut à l'élément multiplicateur 21. À titre d'exemple, le filtre passe-bande 26 est un filtre du 3e ordre.

Selon une particularité, le module de mesure de courant actif 18 comprend un filtre passe-bas 27, connecté entre l'élément multiplicateur 21 et l'élément diviseur 22. Le filtre passe-bas 27 est configuré pour ne laisser passer que la composante continue de la valeur de puissance instantanée P transmise par l'élément multiplicateur 21. À titre d'exemple, le filtre passe-bas 27 est un filtre du 3e ordre.

La liaison électrique 8, telle que décrite ci-dessus, met en œuvre des étapes d'un procédé de fourniture sécurisée d'énergie électrique à un équipement utilisateur 5 d'un véhicule A, par exemple un aéronef.

Au cours d'une étape d'injection de courant, le générateur de courant continue fixe 10 injecte le courant de polarisation Ig au point d'injection 13 de la gaine conductrice 7. Le courant de polarisation Ig et le courant alternatif Ic, créé par la diaphonie capacitive entre le conducteur électrique 4 et la gaine électrique 7, génèrent la tension test Ut aux bornes de la résistance shunt 15. La tension test Ut comprend donc une tension continue Ug et une tension alternative Uc.

Dans un fonctionnement nominal, c'est-à-dire en l'absence de fuite de courant, la tension continue Ug vaut Rs.Ig. Cette tension correspond à la composante continue de la tension test Utdc qui est filtrée, lors d'une étape de mesure de tension continue, par le filtre passe-bas 28 du module de mesure du courant continu 19 puis transmise au comparateur 32. Le comparateur 32 la compare à la valeur de référence Vrdc qui vaut exactement Rs.Ig. Le comparateur 32 transmet le signal de sortie 34 qui est dans un second état E22 au microcontrôleur 35, lequel surveille tout changement d'état du signal de sortie 34.

Au cours d'une étape de mesure de tension alternative, la tension alternative principale Up est atténuée par un facteur prédéterminé par l'élément atténuateur 23 puis filtrée par le premier filtre passe-bande 24. En outre, la tension test Ut est également filtrée par le filtre passe-bande 26. Cette tension test Ut filtrée ne comprend plus que la tension alternative Uc, représentative du couplage capacitif entre le conducteur électrique 4 et la gaine électrique 7. Par ailleurs, le filtre passe-bande 24 et le filtre passe-bande 26 sont identiques afin de conserver un déphasage $\varphi$, qui est égal à $-\pi/2$ dans le cas où il n'y a pas de courant de fuite, entre la tension test Ut filtrée et la tension alternative atténuée Upat filtrée, identique au déphasage entre la tension alternative Uta au borne de la résistance shunt 15, qui est égale à Uc en l'absence de courant de fuite, et la tension alternative principale Up (voir figures 5 et 6).

La tension alternative principale atténuée Upat filtrée et la tension test Ut filtrée sont multipliées, lors d'une étape de multiplication par l'élément multiplicateur 21. Le résultat de cette multiplication correspond à une valeur de puissance instantanée P qui représente la puissance alternative dissipée dans la résistance shunt 15. Comme montré sur les figures 6 et 8, la valeur de puissance instantanée P est une fonction sinusoïdale dont la fréquence est le double de la fréquence de la tension alternative principale atténuée Upat (ou de celle de la tension alternative Uc). Elle présente également un déphasage $\varphi=-\pi/2$ avec la tension alternative principale atténuée Upat en l'absence de courant de fuite. La valeur de puissance instantanée P s'écrit :

$$P(t)=2.(Upat.Uta.\cos(\varphi)) + 2.(Upat.Uta.\cos(4.\pi.F+\varphi)).$$

Le premier terme de la formule précédente correspond à une puissance active Pact, qui est une valeur continue. Le deuxième terme de la formule correspond à une puissance réactive Preact, qui est une valeur alternative. Afin de supprimer cette puissance réactive Preact, le filtre passe-bas 27 est utilisé au cours d'une troisième étape de filtrage. Le filtre passe-bas 27 filtre la valeur de puissance P et ne transmet que sa composante continue, à savoir la puissance active moyenne Pact.

La puissance active moyenne Pact ainsi filtrée est alors divisée, lors d'une étape de division par la valeur de la tension efficace Ueff. La tension efficace Ueff est une tension continue obtenue à partir de la tension alternative principale atténuée Upat en utilisant l'élément convertisseur 25 (voir figure 8). Le résultat de la division par l'élément diviseur 22 est la tension image Uact du courant actif traversant la résistance shunt 15.

Le module de mesure de courant actif 18 transmet alors la valeur de la tension image Uact au comparateur 29, qui la compare à la valeur de référence Vrac. En mode nominal, le déphasage $\varphi=-\pi/2$, présent dans la formule de la valeur de puissance P, conduit à la nullité de la puissance active Pact et donc de la tension image Uact. Dans ce cas, le comparateur 29 transmet le signal de sortie 31 qui est dans le second état E12 au microcontrôleur 35, lequel surveille tout changement d'état du signal de sortie 31.

En revanche, en cas de rupture de la gaine conductrice 7 ou d'une défaillance de l'enveloppe isolante externe 7a, ou d'une une coupure du courant continu Ig ou lorsqu'une fuite de courant apparaît entre la gaine conductrice 7 et, par exemple, la structure conductrice de l'aéronef A : l'arrêt du courant continu ou la fuite de courant se manifeste par une diminution de la tension Ug aux bornes de la résistance shunt 15. Cette tension correspondant à la composante continue de la tension test Utdc, le module de mesure du courant continu 19 mesure une valeur de la composante continue de la tension test Utdc inférieure au produit Rs.Ig et transmet cette valeur au comparateur 32. La composante continue de la tension test Utdc étant inférieure à la valeur de référence Vrdc (Vrdc=Rs.Ig ou légèrement inférieure de façon à tenir compte d'un courant de fuite continu normal dans une installation), le comparateur 32 transmet, au microcontrôleur 35, le signal de sortie 34 dans le premier état E21. Le microcontrôleur 35 interprète alors le changement du second état E22 au premier état E21 du signal de sortie 34 comme indiquant la présence d'une coupure de la gaine conductrice 7 ou d'une fuite de courant et envoie un ordre d'activation 36 au coupe-circuit 9. Ceci déclenche, au cours d'une étape d'activation, l'activation du coupe-circuit 9 qui coupe la liaison électrique 8.

De même, en cas de défaillance de l'enveloppe isolante interne 4a, une fuite de courant apparaît entre le conducteur électrique 4 et la gaine conductrice 7, notamment s'ils rentrent en contact ou si l'espace devient suffisamment petit pour qu'un claquage en tension se déclenche. Le couplage entre le conducteur électrique 4 et la gaine conductrice 7 n'est alors plus purement capacitif, ce qui signifie que le déphasage $\varphi$ entre la tension test Ut et la tension alternative principale atténuée Upat est compris entre $-\pi/2$ et zéro. En conséquence, le premier terme Pact de la formule de la valeur de puissance instantanée P n'est pas égal à zéro (voir figure 8). L'étape de filtrage, par le filtre passe-bas 27 permet d'obtenir la puissance active Pact non nulle.

Après l'étape de division de la puissance active par tension efficace Ueff mise en œuvre par l'élément de division 22, on obtient la valeur de la tension image Uact, image du courant actif traversant la résistance shunt 15, qui est également non nulle. La tension image Uact est ensuite transmise par le module de mesure de courant actif 18 au le module de détection de déviation des courants actifs et continus 20. Comme représenté sur la figure 8, la comparaison de la tension image Uact avec la valeur de référence Vrac, par le comparateur 29, montre que la tension image Uact est supérieure à la tension de référence Vrac. Le comparateur 32 transmet, au microcontrôleur 35, le signal de sortie 31 dans le premier état E11. Le microcontrôleur 35 interprète alors le changement du second état E12 au premier état E11 du signal de sortie 31 comme indiquant la présence d'une fuite de courant et envoie un ordre d'activation 36 au coupe-circuit 9. Ceci déclenche, au cours d'une étape d'activation, l'activation du coupe-circuit 9 qui coupe la liaison électrique 8.

À titre d'exemple, la fréquence F de la tension alternative principale Up est de 800 Hz. Le générateur de courant continu fixe 10 peut délivrer un courant de polarisation Ig de 0.5 A. De plus, la valeur Rs de la résistance shunt 15 est de 20 Ohms.

Par exemple, les filtres passe-bande du 3e ordre ont une fréquence de coupure basse de 100Hz et une fréquence de coupure haute de 2000Hz. Également, la fréquence de coupure basse de filtres passe-bas du 3e ordre est de 100 Hz.

En outre, la valeur de référence de tension continue Vrdc peut être égale à 8 Volts. Dans cet exemple, le coupe-circuit 9 est activé par le microcontrôleur 35 lorsque le courant de fuite Ifdc de la gaine conductrice 7 vers la structure de l'aéronef A dépasse la valeur de :

$$Ifdc=(Rs.Ig-Vrdc)/Rs=0.1 \text{ A.}$$

La valeur de référence de tension alternative Vrac peut être égale à 2 Volts. Dans ce cas, le coupe-circuit 9 est activé par le microcontrôleur 35 lorsque le courant de fuite Ifac entre le conducteur électrique 4 et la gaine conductrice 7 vaut :

$$Ifac=Vrac/Rs=0.1\ A.$$

À titre d'exemple, on considère que la longueur L du conducteur électrique 4 vaut 100 m, que le rayon interne R1 du conducteur électrique 4 vaut 3.5 mm et que le rayon interne R2 de la gaine conductrice 7 est de 7mm. De plus, l'enveloppe isolante interne 4a peut être en polyéthylène dont la permitivité est $\varepsilon r=2.25F/m$. Dans ce cas, la capacité C vaut 18030 pF. Pour une tension Up de 540 Volts sous 800 Hz, le courant réactif vaut 49 mA, et la tension réactive, c'est-à-dire la tension image du courant réactif, aux bornes de la résistance shunt vaut 977 mVolts.

**Revendications**

1. Liaison électrique destinée à relier un générateur de haute tension alternative (2) à un équipement utilisateur (5), la liaison électrique (8) comprenant un conducteur électrique (4) entouré d'une première enveloppe isolante interne (4a), où la liaison électrique (8) comprend un dispositif de protection électrique (3) comprenant :

   - une gaine conductrice (7) agencée autour de l'enveloppe isolante interne (4a) ;
   - un générateur de courant continu fixe (10) connecté à un point d'injection de courant (13) de la gaine conductrice (7) ;
   - un coupe-circuit (9) activable agencé sur le conducteur électrique (4) et configuré pour couper la liaison électrique (8) lorsqu'il est activé ; et
   - un module de détection (11) connecté à un point de prélèvement de courant (14) de la gaine conductrice (7) et au coupe-circuit (9), ledit module de détection (11) étant configuré pour détecter une fuite de courant hors du conducteur électrique (4) et activer le coupe-circuit (9),

   **caractérisée en ce que** ledit module de détection (11) comprenant :

   • une résistance shunt (15) connectée par une première borne entre le point de prélèvement (14) de la gaine conductrice (7) et un point de mesure de courant (16) et par une seconde borne à une masse (17), une tension test (Ut), image d'un courant traversant la résistance shunt (15), étant mesurée aux bornes de la résistance shunt (15) ;
   • un module de mesure de courant actif (18) comprenant un élément multiplicateur (21) et un élément diviseur (22), l'élément multiplicateur (21) ayant une première borne d'entrée connectée au générateur de haute tension alternative (2), une seconde borne d'entrée connectée au point de mesure de courant (16) avec un second filtre passe-bande (26) agencé entre un point de mesure de courant (16) et la seconde borne d'entrée, l'élément diviseur (22) comprenant une première borne d'entrée connectée au générateur de haute tension alternative (2) et une seconde borne d'entrée connectée à une borne de sortie de l'élément multiplicateur (21), l'élément multiplicateur (21) étant configuré pour multiplier une tension alternative principale (Up), générée par le générateur à haute tension alternative (2), par la composante alternative de la tension test (Ut) afin de déterminer une valeur de puissance instantanée (P), ladite valeur de puissance instantanée (P) étant émise par une borne de sortie de l'élément multiplicateur (21), l'élément diviseur (22) étant configuré pour diviser la valeur de puissance (P) par la tension alternative principale (Up) afin de déterminer un première tension (Uact) représentative d'un courant actif traversant la résistance shunt (15), la première tension (Uact) étant présente à une borne de sortie de l'élément diviseur ;
   • un module de mesure de courant continu (19) configuré pour produire une seconde tension (Utdc) représentative du courant continu traversant la résistance shunt (15), ladite seconde tension (Utdc) étant obtenue à partir de la mesure de la composante continue de la tension test (Ut), ladite composante continue de la tension test (Ut) étant obtenu par filtrage de la tension test (Ut) ;
   • un module de détection de déviation des courants actif et continu (20) configuré pour comparer les valeurs des première et seconde tensions (Uact, Utdc) produites par les modules de mesure de courant actif et continu, respectivement, à des valeurs de référence prédéterminées (Vrdc, Vrac) et pour activer ou non le coupe-circuit (9) en fonction du résultat de ces comparaisons.

2. Liaison électrique selon la revendication 1,

**caractérisée en ce que** le module de mesure de courant actif (18) comprend un élément atténuateur (23) apte à être connecté entre le générateur de haute tension alternative (2) et la première borne d'entrée de l'élément diviseur (22), ledit élément atténuateur (23) étant configuré pour atténuer la tension alternative principale (Up) par un facteur prédéterminé afin d'obtenir une tension alternative principale atténuée (Upat), ladite tension alternative principale atténuée (Upat) étant émise par une borne de sortie de l'élément atténuateur (23).

3.  Liaison électrique selon la revendication 2,
    **caractérisée en ce que** le module de mesure de courant actif (18) comprend un premier filtre passe-bande (24) connecté à la borne de sortie de l'élément atténuateur (23).

4.  Liaison électrique selon l'une quelconque des revendications 1 à 3,
    **caractérisée en ce que** le module de mesure de courant actif (18) comprend un élément convertisseur (25) agencé entre une borne de sortie d'un premier filtre passe-bande (24) et une première borne d'entrée d'un élément diviseur (22), ledit élément convertisseur (25) étant configuré pour convertir une tension alternative principale atténuée (Upat), filtrée par un premier filtre passe-bande (24), en une tension efficace (Ueff).

5.  Liaison électrique selon l'une quelconque des revendications 1 à 4,
    **caractérisée en ce que** le module de mesure de courant actif (18) comprend un premier filtre passe-bas (27) agencé entre une borne de sortie d'un élément multiplicateur (21) et une seconde borne d'entrée d'un élément diviseur (22), ledit premier filtre passe-bas (27) étant configuré pour filtrer une valeur de puissance instantanée (P) afin d'obtenir une puissance active moyenne (Pact), ladite puissance active moyenne (Pact) étant émise par une borne de sortie du filtre passe-bas (27).

6.  Liaison électrique selon l'une quelconque des revendications 1 à 5,
    **caractérisée en ce que** le module de mesure de courant continu (19) comprend un second filtre passe-bas (28) agencé entre le point de mesure de courant (16) et une seconde borne d'entrée du module de détection de déviation des courants actif et continu tension (20), configuré pour filtrer la tension test (Ut) afin d'obtenir la composante continue de la tension test, ladite composante continue de la tension test étant émise par une borne de sortie du second filtre passe-bas (28).

7.  Liaison électrique selon l'une quelconque des revendications 1 à 6,
    **caractérisée en ce que** le module de détection de déviation des courants actif et continu (20) est connecté par une première borne d'entrée à une borne de sortie du module de mesure de tension alternative (18), par une seconde borne d'entrée à une borne de sortie du module de mesure de tension continue (19) et par une borne de sortie au coupe-circuit (9), ledit module de détection de déviation des courants actif et continu (19) comprenant :

    - un premier élément comparateur (29) apte à être connecté par une première borne d'entrée à la borne de sortie du module de mesure de courant actif (18) et par une seconde borne d'entrée à un générateur de tension continue (30) fournissant une valeur de référence (Vrac) prédéterminée, ledit premier élément comparateur (29) étant configuré pour comparer la valeur de la première tension (Uact) avec la valeur de référence (Vrac) prédéterminée et émettre un premier signal de sortie (31) indiquant si la composante alternative de la première tension est supérieure ou inférieure ou égale à la valeur de référence (Vrac) prédéterminée ;
    - un second élément comparateur (32) apte à être connecté par une première borne d'entrée à la borne de sortie du module de mesure de courant continu (19) et par une seconde borne d'entrée à un générateur de tension continue (33) fournissant une valeur de référence (Vrdc) prédéterminée, ledit second élément comparateur (32) étant configuré pour comparer la valeur de la seconde tension (Utdc) à la valeur de référence (Vrdc) prédéterminée et émettre un second signal de sortie (34) indiquant si la composante continue de la tension test est supérieure ou inférieure ou égale à la valeur de référence (Vrdc) prédéterminée ; et
    - un microcontrôleur (35) connecté entre une borne de sortie de chaque comparateur (29, 32) et le coupe-circuit (9), ledit microcontrôleur (35) étant configuré pour envoyer un signal d'activation au coupe-circuit (9) si le premier signal de sortie (31), reçu du premier comparateur (29), indique que la valeur de la première tension (Uact) est supérieure à la valeur de référence (Vrac) prédéterminée et/ou si le second signal de sortie (34), reçu du second comparateur (32) indique que la valeur de la seconde tension (Utdc) est inférieure à la valeur de référence (Vrdc) prédéterminée.

8.  Liaison électrique selon l'une quelconque des revendications 1 à 7,
    **caractérisée en ce qu'**une enveloppe isolante externe (7a) entoure la gaine conductrice (7).

**9.** Procédé de fourniture sécurisée d'énergie électrique à un équipement utilisateur (5) d'un véhicule (A) via une liaison électrique (8) connectée entre l'équipement utilisateur (5) et un générateur (2) fournissant une haute tension alternative principale (Up), le véhicule (A) comportant une structure conductrice formant masse (17), la liaison électrique (8) comprenant :

    - un conducteur électrique (4) entouré d'une enveloppe isolante interne (4a) ; et
    - un dispositif de protection électrique (3) comprenant :

        • une gaine conductrice (7) agencée autour d'une enveloppe isolante interne (4a) ;
        • un générateur de courant continu fixe (10) connecté à un point d'injection de courant (13) de la gaine conductrice (7) ;
        • un coupe-circuit activable (9) agencé sur le conducteur électrique (4) et configuré pour couper la liaison électrique lorsqu'il est activé ;
        • un module de détection (11) comprenant une résistance shunt (15) connectée à une liaison électrique (8) comprise entre un point de prélèvement (14) de la gaine conductrice (7) et un point de mesure de courant (16) et à une masse (17), un module de mesure de courant actif (18) comprenant un élément multiplicateur (21) comprenant une première borne d'entrée connectée au générateur de haute tension alternative (2), une seconde borne d'entrée connectée au point de mesure de courant (16) et un élément diviseur (22) comprenant une première borne d'entrée connectée au générateur de haute tension alternative (2), une seconde borne d'entrée connectée à une borne de sortie de l'élément multiplicateur (21), et un module de mesure de courant continu (19) et un module de détection de déviation des courants actif et continu (20), ledit module de détection de déviation des courants actif et continu (20) comprenant un premier comparateur (29), un second comparateur (32) et un microcontrôleur (35) ; et

le procédé comprend les étapes successives suivantes :
- une étape d'injection d'un courant de polarisation (Ig) par le générateur de courant continu fixe (10) au point d'injection du courant (13) ;
- une étape de mesure de la composante continue d'une tension test aux bornes de la résistance shunt (15), mise en œuvre par le module de mesure de courant continu (19), la tension test (Ut) étant l'image du courant traversant la résistance shunt (15) ;

**caractérisé par**

    - une étape de mesure de la composante alternative de la tension test aux bornes de la résistance shunt (15), mise en œuvre par le module de mesure de courant actif (18) ;
    - une étape de génération d'une première tension (Uact) représentative du courant actif traversant la résistance shunt (15) obtenue à partir de la mesure de la composante alternative de la tension test (Ut), mise en œuvre par le module de mesure de courant actif (18) ;
    - une étape de génération d'une seconde tension (Utdc) représentative du courant continu traversant la résistance shunt (15), obtenue à partir de la mesure de la composante continue de la tension test (Ut), mise en œuvre par le module de mesure de courant continu (19) ;
    - une étape de comparaison de la valeur de la première tension (Uact) et de la valeur de la seconde tension (Utdc), respectivement, avec des valeurs de référence prédéterminées (Vrac, Vrdc) ;
    - une étape de surveillance, mise en œuvre par le microcontrôleur (35), de l'état du signal de sortie (31, 34) du premier comparateur (29) et/ou du second comparateur (32), ledit état étant soit un premier état (E11, E21) si la première tension (Uact) est supérieure à la valeur de référence prédéterminée (Vrac) et/ou si la seconde tension (Utdc) est inférieure à la valeur de référence prédéterminée (Vrdc), ledit premier état indiquant la présence d'une fuite de courant entre le conducteur électrique (4) et la gaine conductrice (7), ou la présence d'une fuite de courant hors de la gaine conductrice (7), soit un second état (E12, E22) sinon ;
    - une étape d'activation du coupe-circuit (9), mise en œuvre par le microcontrôleur (35), si le signal de sortie (31, 34) du premier comparateur (29) et/ou du second comparateur (32) est dans le premier état (E11, E21).

**10.** Procédé selon la revendication 9,
**caractérisé en ce que** l'étape de génération de la première tension (Uact), mise en œuvre par le module de mesure de tension alternative (18) comprend les étapes successives suivantes :

    - une étape d'atténuation de la tension alternative principale (Up), mise en œuvre par un élément atténuateur (23) ;

- une première étape de filtrage des perturbations sur la tension alternative principale atténuée (Upat), mise en œuvre par un premier filtre passe-bande (24) ;

- une étape de conversion de la tension alternative principale atténuée et filtrée (Upat) en une tension efficace (Ueff), mise en œuvre par un élément convertisseur (25) ;

- une deuxième étape de filtrage des perturbations sur la tension test (Ut), mise en œuvre par un second filtre passe-bande (26) identique au premier filtre passe-bande ;

- une étape de multiplication de la tension test filtrée (Ut) par la tension alternative principale atténuée (Upat) conduisant à une valeur de puissance instantanée (P), mise en œuvre par un élément multiplicateur (21);

- une troisième étape de filtrage de la composante continue de la puissance instantanée conduisant à une puissance active moyenne (Pact) mise en œuvre par le premier filtre passe-bas (27) ; et

- une étape de division de la puissance active moyenne (Pact) par la tension efficace (Ueff), mise en œuvre par un élément diviseur (22).

**Patentansprüche**

1. Elektrische Verbindung, die zum Anschließen eines Generators für hohe Wechselspannung (2) an ein Benutzergerät (5) bestimmt ist, wobei die elektrische Verbindung (8) einen elektrischen Leiter (4) umfasst, der von einem ersten inneren Isoliermantel (4a) umgeben ist, wobei die elektrische Verbindung (8) eine elektrische Schutzvorrichtung (3) umfasst, umfassend:

- eine leitfähige Hülse (7), die um den inneren Isoliermantel (4a) angeordnet ist;
- einen festen Gleichstromgenerator (10), der mit einem Stromeinspeisepunkt (13) der leitfähigen Hülse (7) verbunden ist;
- einen aktivierbaren Trennschalter (9), der am elektrischen Leiter (4) angeordnet und dazu konfiguriert ist, die elektrische Verbindung (8) zu trennen, wenn er aktiviert ist; und
- ein Detektionsmodul (11), das mit einem Stromentnahmepunkt (14) der leitfähigen Hülse (7) und mit dem Trennschalter (9) verbunden ist, wobei das Detektionsmodul (11) dazu konfiguriert ist, einen Leckstrom außerhalb des elektrischen Leiters (4) zu erkennen und den Trennschalter (9) zu aktivieren, **dadurch gekennzeichnet, dass** das Detektionsmodul (11) umfasst:

• einen Nebenschlusswiderstand (15), der durch eine erste Klemme zwischen dem Entnahmepunkt (14) der leitfähigen Hülse (7) und einem Strommesspunkt (16) und durch eine zweite Klemme an eine Masse (17) angeschlossen ist, wobei eine Prüfspannung (Ut), das Abbild eines Stroms, der durch den Nebenschlusswiderstand (15) fließt, an den Klemmen des Nebenschlusswiderstands (15) gemessen wird;
• ein Wirkstrommessmodul (18), umfassend ein Multiplikationselement (21) und ein Divisionselement (22), wobei das Multiplikationselement (21) eine erste Eingangsklemme, die mit dem Generator für hohe Wechselspannung (2) verbunden ist, und eine zweite Eingangsklemme, die mit dem Strommesspunkt (16) verbunden ist, aufweist, wobei ein zweites Bandpassfilter (26) zwischen einem Strommesspunkt (16) und der zweiten Eingangsklemme angeordnet ist, wobei das Divisionselement (22) eine erste Eingangsklemme umfasst, die mit dem Generator für hohe Wechselspannung (2) verbunden ist, und eine zweite Eingangsklemme, die mit einer Ausgangsklemme des Multiplikationselements (21) verbunden ist, wobei das Multiplikationselement (21) dazu konfiguriert ist, eine Hauptwechselspannung (Up), die vom Generator für hohe Wechselspannung (2) erzeugt wird, mit der Wechselkomponente der Prüfspannung (Ut) zu multiplizieren, um einen Wert der Momentanleistung (P) zu bestimmen, wobei der Wert der Momentanleistung (P) von einer Ausgangsklemme des Multiplikationselements (21) ausgegeben wird, wobei das Divisionselement (22) dazu konfiguriert ist, ist, den Wert der Leistung (P) durch die Hauptwechselspannung (Up) zu dividieren, um eine erste Spannung (Uact) zu bestimmen, die für einen Wirkstrom repräsentativ ist, der durch den Nebenschlusswiderstand (15) fließt, wobei die erste Spannung (Uact) an einer Ausgangsklemme des Divisionselements anliegt;
• ein Gleichstrommessmodul (19), das dazu konfiguriert ist, eine zweite Spannung (Utdc) zu erzeugen, die für den Gleichstrom repräsentativ ist, der durch den Nebenschlusswiderstand (15) fließt, wobei die zweite Spannung (Utdc) durch Messung der Gleichkomponente der Prüfspannung (Ut) erhalten wird, wobei die Gleichkomponente der Prüfspannung (Ut) durch Filterung der Prüfspannung (Ut) erhalten wird;
• ein Modul zur Erkennung einer Abweichung des Wirk- und Gleichstroms (20), das dazu konfiguriert ist, die Werte der ersten und zweiten Spannung (Uact, Utdc), die von dem Wirkstrom- bzw. Gleichstrommessmodul erzeugt werden, mit vorgegebenen Referenzwerten (Vrdc, Vrac) zu vergleichen und den Trennschalter (9) abhängig vom Ergebnis dieser Vergleiche zu aktivieren oder nicht.

**2.** Elektrische Verbindung nach Anspruch 1, **dadurch gekennzeichnet, dass** das Wirkstrommessmodul (18) ein Dämpfungselement (23) umfasst, das fähig ist, zwischen den Generator für hohe Wechselspannung (2) und die erste Eingangsklemme des Divisionselements (22) geschaltet zu werden, wobei das Dämpfungselement (23) dazu konfiguriert ist, die Hauptwechselspannung (Up) mit einem vorgegebenen Faktor zu dämpfen, um eine gedämpfte Hauptwechselspannung (Upat) zu erhalten, wobei die gedämpfte Hauptwechselspannung (Upat) durch eine Ausgangsklemme des Dämpfungselements (23) ausgegeben wird.

**3.** Elektrische Verbindung nach Anspruch 2, **dadurch gekennzeichnet, dass** das Wirkstrommessmodul (18) ein erstes Bandpassfilter (24) umfasst, das mit der Ausgangsklemme des Dämpfungselements (23) verbunden ist.

**4.** Elektrische Verbindung nach einem der Ansprüche 1 bis 3, **dadurch gekennzeichnet, dass** das Wirkstrommessmodul (18) ein Wandlerelement (25) umfasst, das zwischen einer Ausgangsklemme eines ersten Bandpassfilters (24) und einer ersten Eingangsklemme eines Divisionselements (22) angeordnet ist, wobei das Wandlerelement (25) dazu konfiguriert ist, eine gedämpfte Hauptwechselspannung (Upat), die durch ein erstes Bandpassfilter (24) gefiltert wird, in eine effektive Spannung (Ueff) umzuwandeln.

**5.** Elektrische Verbindung nach einem der Ansprüche 1 bis 4, **dadurch gekennzeichnet, dass** das Wirkstrommessmodul (18) ein erstes Tiefpassfilter (27) umfasst, das zwischen einer Ausgangsklemme eines Multiplikationselements (21) und einer zweiten Eingangsklemme eines Divisionselements (22) angeordnet ist, wobei das erste Tiefpassfilter (27) dazu konfiguriert ist, einen Wert der Momentanleistung (P) zu filtern, um eine mittlere Wirkleistung (Pact) zu erhalten, wobei die mittlere Wirkleistung (Pact) durch eine Ausgangsklemme des Tiefpassfilters (27) ausgegeben wird.

**6.** Elektrische Verbindung nach einem der Ansprüche 1 bis 5, **dadurch gekennzeichnet, dass** das Gleichstrommessmodul (19) ein zweites Tiefpassfilter (28) umfasst, das zwischen dem Strommesspunkt (16) und einer zweiten Eingangsklemme des Moduls zur Detektion einer Abweichung des Wirk- und Gleichstroms (20) angeordnet und dazu konfiguriert ist, die Prüfspannung (Ut) zu filtern, um die Gleichkomponente der Prüfspannung zu erhalten, wobei die Gleichkomponente der Prüfspannung durch eine Ausgangsklemme des zweiten Tiefpassfilters (28) ausgegeben wird.

**7.** Elektrische Verbindung nach einem der Ansprüche 1 bis 6, **dadurch gekennzeichnet, dass** das Modul zur Detektion einer Abweichung des Wirk- und Gleichstroms (20) durch eine erste Eingangsklemme mit einer Ausgangsklemme des Wechselspannungsmessmoduls (18), durch eine zweite Eingangsklemme mit einer Ausgangsklemme des Gleichspannungsmessmoduls (19) und durch eine Ausgangsklemme mit dem Trennschalter (9) verbunden ist, wobei das Modul zur Detektion einer Abweichung des Wirk- und Gleichstroms (19) umfasst:

- ein erstes Komparatorelement (29), das fähig ist, durch eine erste Eingangsklemme mit der Ausgangsklemme des Wirkstrommessmoduls (18) und durch eine zweite Eingangsklemme mit einem Gleichspannungsgenerator (30) verbunden zu werden, der einen vorgegebenen Referenzwert (Vrac) liefert, wobei das erste Komparatorelement (29) dazu konfiguriert ist, ist, den Wert der ersten Spannung (Uact) mit dem vorgegebenen Referenzwert (Vrac) zu vergleichen und ein erstes Ausgangssignal (31) auszugeben, das angibt, ob die Wechselkomponente der ersten Spannung größer oder kleiner oder gleich dem vorgegebenen Referenzwert (Vrac) ist;
- ein zweites Komparatorelement (32), das fähig ist, durch eine erste Eingangsklemme mit der Ausgangsklemme des Gleichstrommessmoduls (19) und durch eine zweite Eingangsklemme mit einem Gleichspannungsgenerator (33) verbunden zu werden, der einen vorgegebenen Referenzwert (Vrdc) liefert, wobei das zweite Komparatorelement (32) dazu konfiguriert ist, ist, den Wert der zweiten Spannung (Utdc) mit dem vorgegebenen Referenzwert (Vrdc) zu vergleichen und ein zweites Ausgangssignal (34) auszugeben, das angibt, ob die Gleichkomponente der Prüfspannung größer oder kleiner oder gleich dem vorgegebenen Referenzwert (Vrdc) ist; und
- eine Mikrosteuereinheit (35), die zwischen eine Ausgangsklemme jedes Komparators (29, 32) und den Trennschalter (9) geschaltet ist, wobei die Mikrosteuereinheit (35) dazu konfiguriert ist, ein Aktivierungssignal an den Trennschalter (9) zu senden, wenn das erste Ausgangssignal (31), das vom ersten Komparator (29) empfangen wird, angibt, dass der Wert der ersten Spannung (Uact) größer als der vorgegebene Referenzwert (Vrac) ist, und/oder wenn das zweite Ausgangssignal (34), das vom zweiten Komparator (32) empfangen wird, angibt, dass der Wert der zweiten Spannung (Utdc) kleiner als der vorgegebene Referenzwert (Vrdc) ist.

**8.** Elektrische Verbindung nach einem der Ansprüche 1 bis 7, **dadurch gekennzeichnet, dass** ein äußerer Isoliermantel (7a) die leitfähige Hülse (7) umgibt.

9. Verfahren zur gesicherten Bereitstellung elektrischer Energie an ein Benutzergerät (5) eines Fahrzeugs (A) über eine elektrische Verbindung (8) zwischen dem Benutzergerät (5) und einen Generator (2), der eine hohe Hauptwechselspannung (Up) bereitstellt, wobei das Fahrzeug (A) eine leitfähige Struktur umfasst, die eine Masse (17) bildet, wobei die elektrische Verbindung (8) umfasst:

- einen elektrischen Leiter (4), der von einem inneren Isoliermantel (4a) umgeben ist; und
- eine elektrische Schutzvorrichtung (3), umfassend:

• eine leitfähige Hülse (7), die um den inneren Isoliermantel (4a) angeordnet ist;
• einen festen Gleichstromgenerator (10), der mit einem Stromeinspeisepunkt (13) der leitfähigen Hülse (7) verbunden ist;
• einen aktivierbaren Trennschalter (9), der am elektrischen Leiter (4) angeordnet und dazu konfiguriert ist, die elektrische Verbindung zu trennen, wenn er aktiviert wird; und
• ein Detektionsmodul (11), das einen Nebenschlusswiderstand (15) umfasst, der mit einer elektrischen Verbindung (8) verbunden ist und zwischen einem Stromentnahmepunkt (14) der leitfähigen Hülse (7) und einem Strommesspunkt (16) enthalten ist und mit einer Masse (17) verbunden ist, wobei ein Wirkstrommessmodul (18) ein Multiplikationselement (21) umfasst, umfassend eine erste Eingangsklemme, die mit dem Generator für hohe Wechselspannung (2) verbunden ist, eine zweite Eingangsklemme, die mit dem Strommesspunkt (16) verbunden ist, und ein Divisionselement (22), umfassend eine erste Eingangsklemme, die mit dem Generator für hohe Wechselspannung (2) verbunden ist, eine zweite Eingangsklemme, die mit einer Ausgangsklemme des Multiplikationselements (21) verbunden ist, und ein Gleichstrommessmodul (19) und ein Modul zur Detektion einer Abweichung des Wirk- und Gleichstroms (20), wobei das Modul zur Detektion einer Abweichung des Wirk- und Gleichstroms (20) einen ersten Komparator (29), einen zweiten Komparator (32) und eine Mikrosteuereinheit (35) umfasst; und

das Verfahren die folgenden aufeinanderfolgenden Schritte umfasst:

- einen Schritt der Einspeisung eines Polarisationsstroms (Ig) durch den festen Gleichstromgenerator (10) am Stromeinspeisepunkt (13);
- einen Schritt der Messung der Gleichkomponente einer Prüfspannung an den Klemmen des Nebenschlusswiderstands (15), umgesetzt durch das Gleichstrommessmodul (19), wobei die Prüfspannung (Ut) das Abbild des Stroms ist, der durch den Nebenschlusswiderstand (15) fließt;

**gekennzeichnet durch**

- einen Schritt der Messung der Wechselkomponente der Prüfspannung an den Klemmen des Nebenschlusswiderstands (15), umgesetzt durch das Wirkstrommessmodul (18);
- einen Schritt der Erzeugung einer ersten Spannung (Uact), die für den Wirkstrom repräsentativ ist, der durch den Nebenschlusswiderstand (15) fließt, und die durch Messung der Wechselkomponente der Prüfspannung (Ut) erhalten wird, umgesetzt durch das Wirkstrommessmodul (18);
- einen Schritt der Erzeugung einer zweiten Spannung (Utdc), die für den Gleichstrom repräsentativ ist, der durch den Nebenschlusswiderstand (15) fließt, und die durch die Messung der Gleichkomponente der Prüfspannung (Ut) erhalten wird, umgesetzt durch das Gleichstrommessmodul (19);
- einen Schritt des Vergleichs des Werts der ersten Spannung (Uact) bzw. des Werts der zweiten Spannung (Utdc) mit den vorgegebenen Referenzwerten (Vrac, Vrdc);
- einen Schritt der Überwachung des Zustands des Ausgangssignals (31, 34) des ersten Komparators (29) und/oder des zweiten Komparators (32), umgesetzt durch die Mikrosteuereinheit (35), wobei der Zustand entweder ein erster Zustand (E11, E21) ist, wenn die erste Spannung (Uact) größer als der vorgegebene Referenzwert (Vrac) ist und/oder wenn die zweite Spannung (Utdc) kleiner als der vorgegebene Referenzwert (Vrdc) ist, wobei der erste Zustand das Vorliegen eines Leckstroms zwischen dem elektrischen Leiter (4) und der leitfähigen Hülse (7) oder das Vorliegen eines Leckstroms außerhalb der leitfähigen Hülse (7) ist, oder andernfalls ein zweiter Zustand (E12, E22);
- einen Schritt der Aktivierung des Trennschalters (9), umgesetzt durch die Mikrosteuereinheit (35), wenn sich das Ausgangssignal (31, 34) des ersten Komparators (29) und/oder des zweiten Komparators (32) im ersten Zustand (E11, E21) befindet.

10. Verfahren nach Anspruch 9, **dadurch gekennzeichnet, dass** der Schritt der Erzeugung der ersten Spannung (Uact), umgesetzt durch das Wechselspannungsmessmodul (18) die folgenden aufeinanderfolgenden Schritte umfasst:

- einen Schritt der Dämpfung der Hauptwechselspannung (Up), umgesetzt durch ein Dämpfungselement (23);
- einen ersten Schritt der Filterung der Störungen an der gedämpften Hauptwechselspannung (Upat), umgesetzt durch ein erstes Bandpassfilter (24);
- einen Schritt der Umwandlung der gedämpften und gefilterten Hauptwechselspannung (Upat) in eine effektive Spannung (Ueff), umgesetzt durch ein Wandlerelement (25);
- einen zweiten Schritt der Filterung der Störungen an der Prüfspannung (Ut), umgesetzt durch ein zweites Bandpassfilter (26), das mit dem ersten Bandpassfilter identisch ist;
- einen Schritt der Multiplikation der gefilterten Prüfspannung (Ut) mit der gedämpften Hauptwechselspannung (Upat), der zu einem Wert der Momentanleistung (P) führt, umgesetzt durch ein Multiplikationselement (21);
- einen dritten Schritt der Filterung der Gleichkomponente der Momentanleistung, der zu einer mittleren Wirkleistung (Pact) führt, umgesetzt durch das erste Tiefpassfilter (27); und
- einen Schritt der Division der mittleren Wirkleistung (Pact) durch die effektive Spannung (Ueff), umgesetzt durch ein Divisionselement (22).

## Claims

1. Electrical link intended to link a high AC voltage generator (2) to a user device (5), the electrical link (8) comprising an electrical conductor (4) surrounded by a first internal insulating jacket (4a),
   in which the electrical link (8) comprises an electrical protection device (3) comprising:

   - a conductive sheath (7) arranged around the internal insulating jacket (4a);
   - a fixed DC current generator (10) connected to a current injection point (13) of the conductive sheath (7) ;
   - an activatable circuit breaker (9) arranged on the electrical conductor (4) and configured to break the electrical link (8) when it is activated; and
   - a detection module (11) connected to a current tapping point (14) of the conductive sheath (7) and to the circuit breaker (9), said detection module (11) being configured to detect a current leak from the electrical conductor (4) and activate the circuit breaker (9),

   **characterized in that** said detection module (11) comprises:

   • a shunt resistor (15) connected by a first terminal between the tapping point (14) of the conductive sheath (7) and a current measurement point (16) and by a second terminal to a ground (17), a test voltage (Ut), the image of a current flowing through the shunt resistor (15), being measured at the terminals of the shunt resistor (15);
   • an active current measurement module (18) comprising a multiplier element (21) and a divider element (22), the multiplier element (21) having a first input terminal connected to a high AC voltage generator (2), a second input terminal connected to the current measurement point (16) with a second bandpass filter (26) arranged between a current measurement point (16) and the second input terminal, the divider element (22) comprising a first input terminal connected to the high AC voltage generator (2) and a second input terminal connected to an output terminal of the multiplier element (21), the multiplier element (21) being configured to multiply a main AC voltage (Up), generated by the high AC voltage generator (2), by the AC component of the test voltage (Ut) in order to determine an instantaneous power value (P), said instantaneous power value (P) being transmitted by an output terminal of the multiplier element (21), the divider element (22) being configured to divide the power value (P) by the main AC voltage (Up) in order to determine a first voltage (Uact) representative of an active current flowing through the shunt resistor (15), the first voltage (Uact) being present at an output terminal of the divider element;
   • a DC current measurement module (19) configured to produce a second voltage (Utdc) representative of the DC current flowing through the shunt resistor (15), said second voltage (Utdc) being obtained from the measurement of the DC component of the test voltage (Ut), said DC component of the test voltage (Ut) being obtained by the filtering of the test voltage (Ut);
   • a module for detecting deviation of the active and DC currents (20) configured to compare the values of the first and second voltages (Uact, Utdc) produced by the active and DC current measurement modules, respectively, to predetermined reference values (Vrdc, Vrac) and to activate or not the circuit breaker (9) as a function of the result of these comparisons.

2. Electrical link according to Claim 1,

**characterized in that** the active current measurement module (18) comprises an attenuator element (23) capable of being connected between the high AC voltage generator (2) and the first input terminal of the divider element (22), said attenuator element (23) being configured to attenuate the main AC voltage (Up) by a predetermined factor in order to obtain an attenuated main AC voltage (Upat), said attenuated main AC voltage (Upat) being transmitted by an output terminal of the attenuator element (23).

3. Electrical link according to Claim 2,
   **characterized in that** the active current measurement module (18) comprises a first bandpass filter (24) connected to the output terminal of the attenuating element (23).

4. Electrical link according to any one of Claims 1 to 3,
   **characterized in that** the active current measurement module (18) comprises a converter element (25) arranged between an output terminal of a first bandpass filter (24) and a first input terminal of a divider element (22), said converter element (25) being configured to convert an attenuated main AC voltage (Upat), filtered by a first bandpass filter (24), into an root mean square voltage (Ueff).

5. Electrical link according to any one of Claims 1 to 4,
   **characterized in that** the active current measurement module (18) comprises a first low-pass filter (27) arranged between an output terminal of a multiplier element (21) and a second input terminal of a divider element (22), said first low-pass filter (27) being configured to filter an instantaneous power value (P) in order to obtain a mean active power (Pact), said mean active power (Pact) being transmitted by an output terminal of the low-pass filter (27).

6. Electrical link according to any one of Claims 1 to 5,
   **characterized in that** the DC current measurement module (19) comprises a second low-pass filter (28), arranged between the current measurement point (16) and a second input terminal of the module for detecting deviation of the active and DC voltage currents (20), configured to filter the test voltage (Ut) in order to obtain the DC component of the test voltage, said DC component of the test voltage being transmitted by an output terminal of the second low-pass filter (28).

7. Electrical link according to any one of Claims 1 to 6,
   **characterized in that** the module for detecting deviation of the active and DC currents (20) is connected by a first input terminal to an output terminal of the AC voltage measurement module (18), by a second input terminal to an output terminal of the DC voltage measurement module (19) and by an output terminal to the circuit breaker (9), said module for detecting deviation of the active and DC currents (19) comprising:

   - a first comparator element (29) capable of being connected by a first input terminal to the output terminal of the active current measurement module (18) and by a second input terminal to a DC voltage generator (30) supplying a predetermined reference value (Vrac), said first comparator element (29) being configured to compare the value of the first voltage (Uact) with the predetermined reference value (Vrac) and transmit a first output signal (31) indicating whether the AC component of the first voltage is greater than or less than or equal to the predetermined reference value (Vrac);
   - a second comparator element (32) capable of being connected by a first input terminal to the output terminal of the DC current measurement module (19) and by a second input terminal to a DC voltage generator (33) supplying a predetermined reference value (Vrdc), said second comparator element (32) being configured to compare the value of the second voltage (Utdc) to the predetermined reference value (Vrdc) and transmit a second output signal (34) indicating whether the DC component of the test voltage is greater than or less than or equal to the predetermined reference value (Vrdc); and
   - a microcontroller (35) connected between an output terminal of each comparator (29, 32) and the circuit breaker (9), said microcontroller (35) being configured to send an activation signal to the circuit breaker (9) if the first output signal (31), received from the first comparator (29), indicates that the value of the first voltage (Uact) is greater than the predetermined reference value (Vrac) and/or if the second output signal (34), received from the second comparator (32) indicates that the value of the second voltage (Utdc) is less than the predetermined reference value (Vrdc).

8. Electrical link according to any one of Claims 1 to 7,
   **characterized in that** an outer insulating jacket (7a) surrounds the conductive sheath (7).

9. Method for the secure supply of electrical energy to a user device (5) of a vehicle (A) via an electrical link (8) connected between the user device (5) and a generator (2) supplying a main high AC voltage (Up), the vehicle (A) comprising a ground-forming conductive structure (17), the electrical link (8) comprising:

- an electrical conductor (4) surrounded by an internal insulating jacket (4a); and
- an electrical protection device (3) comprising:

  • a conductive sheath (7) arranged around an internal insulating jacket (4a);
  • a fixed DC current generator (10) connected to a current injection point (13) of the conductive sheath (7);
  • an activatable circuit breaker (9) arranged on the electrical conductor (4) and configured to break the electrical link when it is activated;
  • a detection module (11) comprising a shunt resistor (15) connected to an electrical link (8) comprised between a tapping point (14) of the conductive sheath (7) and a current measurement point (16) and to a ground (17), an active current measurement module (18) comprising a multiplier element (21) comprising a first input terminal connected to the high AC voltage generator (2), a second input terminal connected to the current measurement point (16) and a divider element (22) comprising a first input terminal connected to the high AC voltage generator (2), a second input terminal connected to an output terminal of the multiplier element (21), and a DC current measurement module (19) and a module for detecting deviation of the active and DC currents (20), said module for detecting deviation of the active and DC currents (20) comprising a first comparator (29), a second comparator (32) and a microcontroller (35); and

the method comprises the following successive steps:

- a step of injection of a bias current (Ig) by the fixed DC current generator (10) at the current injection point (13) ;
- a step of measurement of the DC component of a test voltage at the terminals of the shunt resistor (15), implemented by the DC current measurement module (19), the test voltage (Ut) being the image of the current flowing through the shunt resistor (15);

**characterized by**

- a step of measurement of the AC component of the test voltage at the terminals of the shunt resistor (15), implemented by the active current measurement module (18) ;
- a step of generation of a first voltage (Uact) representative of the active current flowing through the shunt resistor (15) obtained from the measurement of the AC component of the test voltage (Ut), implemented by the active current measurement module (18);
- a step of generation of a second voltage (Utdc) representative of the DC current flowing through the shunt resistor (15), obtained from the measurement of the DC component of the test voltage (Ut), implemented by the DC current measurement module (19);
- a step of comparison of the value of the first voltage (Uact) and of the value of the second voltage (Utdc), respectively, with predetermined reference values (Vrac, Vrdc);
- a step of monitoring, implemented by the microcontroller (35), the state of the output signal (31, 34) of the first comparator (29) and/or of the second comparator (32), said state being either a first state (E11, E21) if the first voltage (Uact) is greater than a predetermined reference value (Vrac) and/or if the second voltage (Utdc) is less than the predetermined reference value (Vrdc), said first state indicating the presence of a current leak between the electrical conductor (4) and the conductive sheath (7), or the presence of a current leak out of the conductive sheath (7), or a second state (E12, E22) otherwise;
- a step of activation of the circuit breaker (9), implemented by the microcontroller (35), if the output signal (31, 34) of the first comparator (29) and/or of the second comparator (32) is in the first state (E11, E21) .

10. Method according to Claim 9,
**characterized in that** the step of generation of the first voltage (Uact), implemented by the AC voltage measurement module (18) comprises the following successive steps:

- a step of attenuation of the main AC voltage (Up), implemented by an attenuator element (23);
- a first step of filtering of the disturbances on the attenuated main AC voltage (Upat), implemented by a first bandpass filter (24);
- a step of conversion of the attenuated and filtered main AC voltage (Upat) into an root mean square voltage (Ueff), implemented by a converter element (25);
- a second step of filtering of the disturbances on the test voltage (Ut), implemented by a second bandpass filter (26) identical to the first bandpass filter;

- a step of multiplication of the filtered test voltage (Ut) by the attenuated main AC voltage (Upat) leading to an instantaneous power value (P), implemented by a multiplier element (21);

- a third step of filtering of the DC component of the instantaneous power leading to a mean active power (Pact) implemented by the first low-pass filter (27); and

- a step of division of the mean active power (Pact) by the root mean square voltage (Ueff), implemented by a divider element (22).

Fig. 1

Fig. 2

Fig. 3

Fig. 4

EP 3 483 999 B1

Fig. 5

Fig. 6

Fig. 7

Fig. 8

Fig. 9

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

• US 2006017445 A